(19) Europäisches Patentamt / European Patent Office / Office européen des brevets

(11) **EP 1 834 462 B1**

(12) **EUROPEAN PATENT SPECIFICATION**

(45) Date of publication and mention
of the grant of the patent:
**24.04.2013 Bulletin 2013/17**

(51) Int Cl.:
***H04L 27/26*** *(2006.01)*   ***H03G 11/00*** *(2006.01)*

(21) Application number: **06700055.4**

(22) Date of filing: **05.01.2006**

(86) International application number:
**PCT/FI2006/050009**

(87) International publication number:
**WO 2006/072669 (13.07.2006 Gazette 2006/28)**

(54) **Clipping of transmission signal**

Sendesignalbegrenzung

Écretage d'un signal de transmission

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **07.01.2005 FI 20055012
08.03.2005 US 74006**

(43) Date of publication of application:
**19.09.2007 Bulletin 2007/38**

(73) Proprietor: **Nokia Siemens Networks Oy
02610 Espoo (FI)**

(72) Inventor: **PIIRAINEN, Olli
FI-90100 Oulu (FI)**

(56) References cited:
**EP-A2- 1 282 225       EP-A2- 1 424 822
EP-B1- 0 751 630       EP-B1- 1 396 970
WO-A2-02/11283        GB-A- 2 402 308
US-A1- 2004 090 283   US-A1- 2005 169 411**

• **AGGARWAL A ET AL: "Minimizing the peak-to-
average power ratio of OFDM signals via convex
optimization", GLOBECOM'03. 2003 - IEEE
GLOBAL TELECOMMUNICATIONS
CONFERENCE. CONFERENCE PROCEEDINGS.
SAN FRANCISCO, CA, DEC. 1 - 5, 2003; [IEEE
GLOBAL TELECOMMUNICATIONS
CONFERENCE], NEW YORK, NY : IEEE, US, vol.
4, 1 December 2003 (2003-12-01), pages
2385-2389, XP010677782, DOI:
10.1109/GLOCOM.2003.1258662 ISBN:
978-0-7803-7974-9**
• **AGGARWAL A ET AL: "Globally Optimal Tradeoff
Curves for OFDM PAR Reduction", IEEE
WORKSHOP ON SIGNAL PROCESSING
SYSTEMS 2004 (SIPS 2004), 13-15 OCTOBER
2004, IEEE, 13 October 2004 (2004-10-13), pages
12-17, XP010743928, DOI: 10.1109/SIPS.
2004.1363017 ISBN: 978-0-7803-8504-7**

## Description

### Field

The invention relates to restriction of strength of a signal in a radio transmitter.

### Background

In a radio system linearity of a power amplifier limits the obtainable maximum transmit power, especially when the signal to be transmitted has a high peak to average power ratio (PAPR). In such a case the signal input to the power amplifier may exhibit momentarily high power that must be taken into account in designing the power amplifier. This means in practice that an output signal of the amplifier is scaled down to a lower power level in order to meet the spectral requirements of the data transmission system currently in use. Due to this, the signal to be amplified is biased such that the transfer function of the amplifier becomes more linear. However, this reduces the efficiency of the amplifier and/or the transmitter. Secondly, power amplifiers with a broad linear operating range are expensive.

Signal components exceeding a threshold can also be clipped by limiting the peak values to the threshold. The other signal values below the threshold are not changed. However, a problem with the clipping methods is that the signal frequency spectrum spreads, i.e. usually the spectrum spreads beyond the frequency band that is used, thus causing interference to other users. If the spreading of spectrum is limited, the PAPR remains high.

The document GB2402308 discloses a method in which a cost function is used to find an optimisation signal which, when filtered, is as close as possible to hard clipping. The cost function includes constraints for the amplitude, the EVM and the spectrum. This filtered optimisation signal is then used to clip the transmission signal.

### Brief description of the invention

An object of the invention is to provide an improved method, an improved transmitter, and an improved base station. According to an aspect of the invention, there is provided a method of clipping a transmission signal in a radio system, the method comprising clipping a transmission signal in the transmitter before transmission in order to reduce the strength of at least one peak of the transmission signal exceeding a predetermined threshold. The method further comprises performing a minimization of a cost function with respect to an optimisation signal, the cost function having weighted terms as a function of the optimisation signal, the terms relating to an effective modulation distortion and an effective overshoot exceeding the predetermined threshold; forming a clipping signal by filtering the optimisation signal formed as a result of the minimization according to the spectrum emission mask requirements of the radio system; and subtracting the clipping signal from the transmission signal.

According to another aspect of the invention, there is provided a transmitter in a radio system, the transmitter being configured to clip a transmission signal before transmission in order to reduce the strength of at least one peak of the transmission signal exceeding a predetermined threshold. The transmitter further comprises a clipper comprising a minimizer for minimizing of a cost function with respect to an optimisation signal, the cost function having weighted terms as a function of the optimisation signal, the terms relating to an effective modulation distortion and an effective overshoot exceeding the predetermined threshold; a filter for forming a clipping signal by filtering the optimisation signal formed as a result of the minimization according to the spectrum emission mask requirements of the radio system; and an adder for subtracting the clipping signal from the transmission signal.

According to another aspect of the invention, there is provided a base station in a radio system, the base station being configured to clip a transmission signal before transmission in order to reduce the strength of at least one peak of the transmission signal exceeding a predetermined threshold. The base station further comprises a minimizer for minimizing of a cost function with respect to an optimisation signal, the cost function having weighted terms as a function of the optimisation signal, the terms relating to an effective modulation distortion and an effective overshoot exceeding the predetermined threshold; a filter for forming a clipping signal by filtering the optimisation signal formed as a result of the minimization according to the spectrum emission mask requirements of the radio system; and an adder for subtracting the clipping signal from the transmission signal.

The invention provides several advantages. The PAPR can be effectively lowered without unnecessarily spreading the spectrum beyond the allowable frequency band.

### List of drawings

In the following, the invention will be described in greater detail with reference to the embodiments and the accompanying drawings, in which

Figure 1 shows a radio system,
Figure 2 illustrates a transmitter,
Figure 3A illustrates a transmission signal with high peaks,
Figure 3B illustrates a clipped transmission signal,
Figure 4 illustrates a clipper,
Figure 5 illustrates a signal constellation,
Figure 6 illustrates a FIR filter,
Figure 7A - 7C illustrate a division of a transmission signal into subsignals, and
Figure 8 illustrates a flow chart of the method.

## Description of embodiments

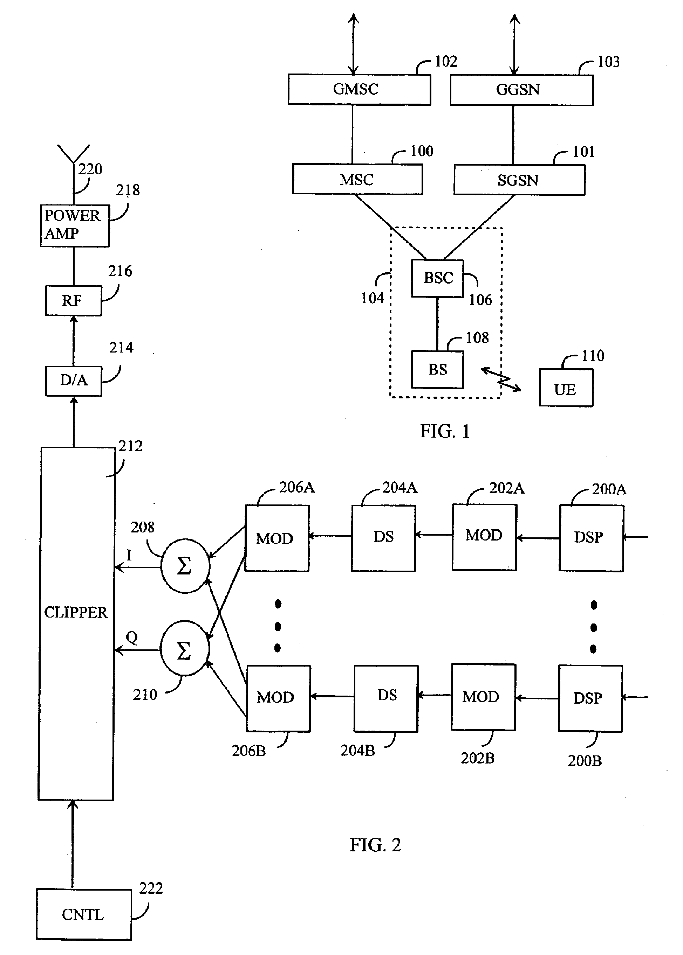

Let us first study Figure 1 that illustrates the structure of a radio system. The radio system can be based on, for example, UMTS (Universal Mobile Telephone System) or WCDMA (Wide-band Code Division Multiple Access).

The core network may, for example, correspond to the combined structure of the GSM (Global System for Mobile Communications) and GPRS (General Packet Radio Service) systems. The GSM network elements are responsible for the implementation of circuit-switched connections, and the GPRS network elements for the implementation of packet-switched connections, some of the network elements being, however, shared by both systems.

A mobile services switching centre (MSC) 100 enables circuit-switched signalling in the radio system. A serving GPRS support node (SGSN) 101 in turn enables packet-switched signalling. All traffic in the radio system may be controlled by the MSC 100.

The core network may have a gateway unit 102, which represents a gateway mobile service switching centre (GMSC) for attending to the circuit-switched connections between the core network and external networks, such as a public land mobile network (PLMN) or a public switched telephone network (PSTN). A gateway GPRS support node (GGSN) 103 attends to the packet-switched connections between the core network and external networks, such as the Internet.

The MSC 100 and the SGSN are connected to a radio access network (RAN) 104, which may comprise at least one base station controller 106 controlling at least one base station 108. The base station controller 106 can also be called a radio network controller, and the base station can be called a node B. A user terminal 110 communicates with at least one base station 108 over a radio interface.

The user terminal 110 can communicate with the base station 108 using a GPRS method. Data in packets contain address and control data in addition to the actual traffic data. Several connections may employ the same transmission channel simultaneously.

Orthogonal frequency division multiplexing (OFDM) scheme is also a possible choice for communication between the base station and the user terminal. In the OFDM technique data is transmitted using a plurality of subcarriers instead of one wideband signal. The OFDM scheme combined with CDMA scheme has a tendency to produce high peaks to mean amplitude.

Fig. 2 illustrates a transmitter in the radio system. The transmitter is usually the base station of the radio system but it may also be some other transmitter of the radio system. The transmitter can be a single carrier transmitter or a multicarrier transmitter. The multicarrier transmitter includes the signal-processing units 200A to 200B, data modulators 202A to 202B, spreading units 204A to 204B, and modulators 206A to 206B. The number of the carriers required in a multicarrier system may vary in different applications.

The signal-processing units 200A to 200B, which may be a digital signal processors (DSP), process user speech or data in the transmitter. The signal processing may include, for example, coding and encryption. If the transmission is carried out in frames, which consist of time slots, the frames are typically formed and symbols can also be interleaved in the DSP. The purpose of signal coding and interleaving is to ensure that the transmitted information can be restored in the receiver in spite of lost of information during fading. In a data modulators 202A to 202B, the data signal is modulated by a desired modulation method. A possible modulation method is, for example, a quadrature phase shift keying (QPSK) where the signal is divided into in-phase I and quadrature Q components.

In the spreading units 204A to 204B, the narrowband data signal is multiplied by a spreading code in order to spread the band.

The modulators 206A to 206B which may perform IDFT (Inverse Discrete Fourier Transform) or IFFT (Inverse Fast Fourier Transform) are needed if a transmitter is a multicarrier transmitter. A single carrier transmitter does not have the modulators 206A to 206B. The modulators 206A to 206B form plurality of carriers organized on the frequency domain in a manner applicable to the system used. This kind of multicarrier CDMA transmitter based on an OFDM scheme is an example of a multicarrier transmitter.

Since the signal may have in the in-phase (I) and quadrature (Q) component after each modulator 206A to 206B, the multicarrier transmitter comprises two adders 208, 210, one of which adds together the in-phase components of the different carriers and the other one adds together the quadrature components thereof.

A clipper 212 clips the effective strength of the signal exceeding the threshold value. The signal may be a complex signal including an in-phase part and a quadrature-phase part. The strength can be expressed as energy, power or absolute amplitude. The clipper 212 may also reside before the modulators 206A to 206B.

The clipper 212 outputs the clipped signal to D/A transformer 214 which converts a signal of a digital form into a signal of an analog form. The mixer 216 up-converts the signal onto a selected radio frequency either directly or through an intermediate frequency, whereafter the signal is amplified in a power amplifier 218. The antenna 220 transmits the amplified signal as electromagnetic radiation for the user terminal(s).

A control unit 222 controls the operation of the clipper 212. The control unit 222 may control, for example, the threshold A of clipping and weights $\alpha$, $\mu$ possibly used in the method.

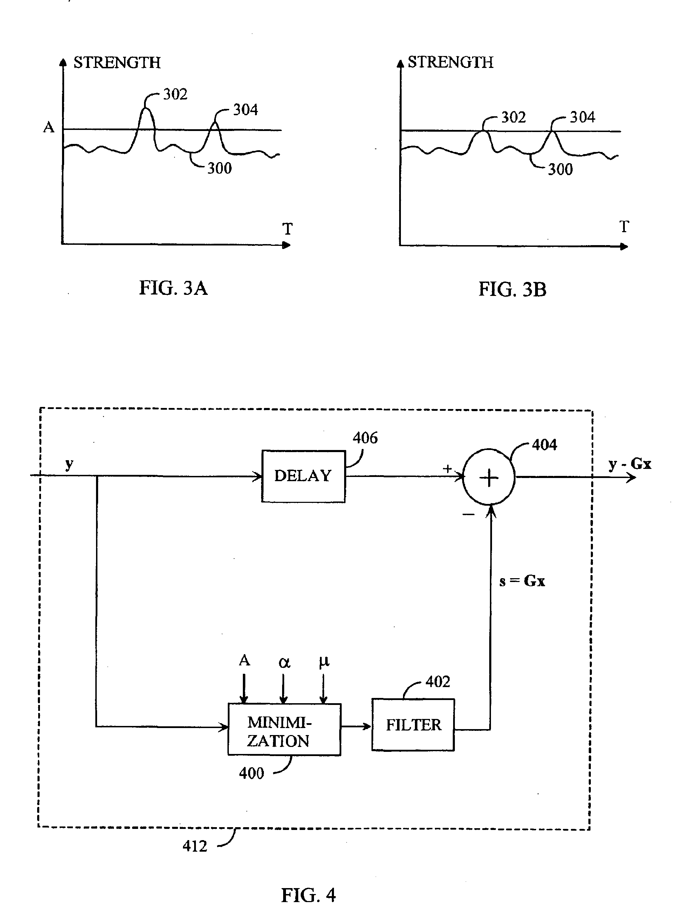

Figure 3A shows a transmission signal 300 which has high peaks 302 and 304 without clipping. The vertical axis may measure amplitude or power and the horizontal axis is time. Both axes have arbitrary scale. The threshold level is A.

Figure 3B shows the same transmission signal 300 after the transmission signal has been clipped. The peaks 302, 304 are now lower, the highest values being about the threshold A.

Fig. 4 illustrates the clipper 212 the purpose of which is to reduce the strength of at least one peak of the transmission signal exceeding a predetermined threshold. A signal y is an input to the clipper 212 and as a vector it can be expressed as **y**. The signal enters a minimizer 400 which outputs an optimisation signal x which can be expressed in matrix form as **x**. The optimisation signal **x** is filtered in a filter 402 which fulfils the requirements of spectrum emission mask (SEM) of the radio system. The filter 402 can be expressed as a convolution matrix **G** because the filter performs a convolution based on a vector **g**. In a summer 404 the clipping signal **Gx** output by the filter 402 is subtracted from the transmission signal **y** which is delayed in a delay element 406. The subtraction reduces the strength of peaks in the signal **y** and the signal output by the summer 404 can be expressed as **y - Gx = y - s**. The delay element 406 delays the transmission signal **y** as much as the minimizer 400 and the filter 402 cause delay to the clipping signal **s**.

The minimizer 400 performs a minimization of a cost function with respect to the optimisation signal **x**. The cost function J(**x**) can be expressed as

$$J(\mathbf{x}) = \alpha f_1(\mathbf{x}) + (1 - \alpha)f_2(\mathbf{x}), \tag{1}$$

where the argument **x** is an optimisation signal expressed in a vector form, the term $f_1(\mathbf{x})$ relates to an effective modulation distortion of the clipped transmission signal and the term $f_2(\mathbf{x})$ relates to an effective overshoot exceeding the predetermined threshold of the clipped signal, $\alpha$ and $(1 - \alpha)$ are weights $(0 \leq \alpha \leq 1)$ having real values. To give more weight to the second term, the weight $\alpha$ should be less than 0.5. The modulation distortion can also be considered as a waveform distortion.

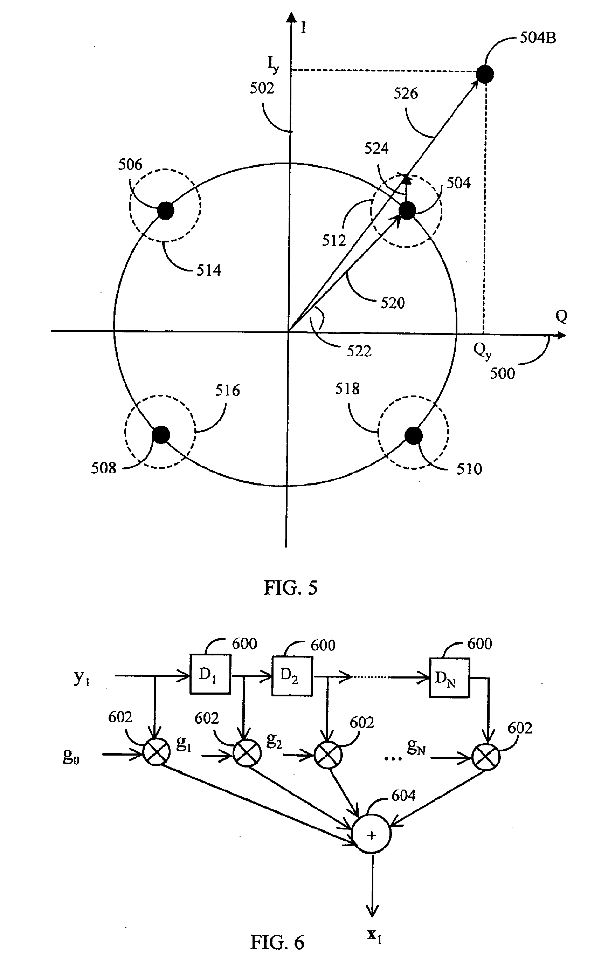

Fig. 5 shows a simple example of a signal constellation, modulation distortion and an overshoot. The horizontal axis 500 shows a quadrature component of the modulated signal and the vertical axis 502 shows an in-phase component. Points 504, 506, 508 and 510 denote non-distorted modulation symbols (or ideal symbols) in the signal constellation. The amplitude of the non-distorted symbols may be constant but the phase varies. The number of the states in the signal constellation depends on the modulation method used: the more symbols the greater the possible data transmission capacity of the system. The small circles 512, 514, 516, 518 denote a limit L of measured symbols i.e. non-ideal symbols which are usually always distorted to some extent. The predetermined threshold A can be expressed as A = $|_{yideal\ symbol}|^+$ $|L|$.

A pointer 520 represents the amplitude and phase of one measured symbol which can be expressed as $Re^{j(2\pi ft + \phi)}$, where R is the signal amplitude, f is a frequency, t is time and $\phi$ is a phase. An angle 522 denotes the phase

$\phi$ of the symbol. The amplitude R can be defined as $R = \sqrt{(I_y^2 + Q_y^2)}$, i.e. the amplitude is the square root of the sum of the square of the in-phase value and the quadrature value.

An arrow 524 denotes an acceptable error vector inside the circle 512. An arrow 526 denotes an error vector exceeding the threshold A. The complete error vector due to distortion is a sum of the error vectors 524 and 526 pointing to a symbol 504B. It can be considered that the symbol 504 is shifted from an ideal position to a displaced position 504B.

The error of the displacement can be measured as an error vector magnitude (EVM). The EVM is an indicator for the quality or distortion of modulation. The EVM defines a deviation of the measured waveform from the ideal one and it can be used to measure a single-code or a multicode signal. The peak code domain error (PCDE) can be used to define a difference between a signal and a corresponding ideal signal projected onto the code space used having a specific spreading factor, and the PCDE can be applied for multicode signals only. Hence, the PCDE is an indicator of the distribution of modulation errors over spreading codes. The error indicator EVM and PCDE are related to each other. For example, if the error is evenly distributed among the spreading codes, the PCDE can be expressed as

$$PCDE = 10 \cdot \log_{10}(EVM^2/SF), \qquad (2)$$

where SF denotes a spreading factor.

The term $f_1(\mathbf{x})$ in (1) can be expressed as

$$f_1(\mathbf{x}) = \mathbf{x}^H \mathbf{G}^H \mathbf{C}^H \mathbf{C} \mathbf{G} \mathbf{x}, \qquad (3)$$

where the upper index H means a Hermitian form of a vector or a matrix (the elements of a vector or a matrix $\mathbf{a}^H$ are complex conjugates of the vector or the matrix $\mathbf{a}$), and $\mathbf{G}$ means the convolution matrix. The matrix $\mathbf{C}$ may, in principle, mean a matrix $\mathbf{B}$ or a matrix $\mathbf{G}^{-1}$, where the upper index -1 inverses the matrix $\mathbf{G}$). The matrix $\mathbf{B}$ can be considered similar to a convolution matrix of a root raised cosine (RRC) filter of a measurement set up measuring the EVM. In the case the matrix $\mathbf{C}$ corresponds the matrix $\mathbf{G}^{-1}$, the term $f_1(\mathbf{x})$ becomes $f_1(\mathbf{x}) = \mathbf{x}^H \mathbf{x}$ and in this case it is not necessary to perform the part of the multiplication $\mathbf{G}^H \mathbf{C}^H \mathbf{C} \mathbf{G}$ at all, since the product $\mathbf{G}^H \mathbf{C}^H \mathbf{C} \mathbf{G}$ becomes an identity matrix $\mathbf{I}$. The term $f_1(\mathbf{x}) = \mathbf{x}^H \mathbf{x}$ can be accomplished by forming an effective value of the optimisation signal $\mathbf{x}$.

The matrix $\mathbf{C}$ may also be an identity matrix $\mathbf{I}$. In that case, the term $f_1(\mathbf{x})$ becomes $f_1(\mathbf{x}) = \mathbf{x}^H \mathbf{G}^H \mathbf{G} \mathbf{x}$. The term $f_1(\mathbf{x})$ can be accomplished by filtering the optimisation signal $\mathbf{x}$ with a suitable FIR filter defined by the matrix $\mathbf{G}$ and forming an effective value of the result.

In the case the convolution matrix $\mathbf{G}$ is omitted, the term $f_1(\mathbf{x})$ becomes $f_1(\mathbf{x}) = \mathbf{x}^H \mathbf{B}^H \mathbf{B} \mathbf{x}$. The term $f_1(\mathbf{x})$ can be accomplished by filtering the optimisation signal $\mathbf{x}$ with a suitable FIR filter (RRC filter) defined by the matrix $\mathbf{B}$ and forming an effective value of the result.

The term $f_1(\mathbf{x})$ in (1) can be expressed in a multicode system as

$$f_1(\mathbf{x}) = f(\mathbf{x}^H \mathbf{G}^H \mathbf{C}_i^H \mathbf{C}_i \mathbf{G} \mathbf{x}), \qquad (4)$$

Here the matrix $\mathbf{C}_i$ may, in principle, mean the matrix $\mathbf{B}$, the matrix $\mathbf{G}^{-1}$ or a product of matrices $\mathbf{S}_i \mathbf{B}$, where the matrix $\mathbf{S}_i$ means a spreading code i used in a multicode radio system. The product of matrices $\mathbf{S}_i \mathbf{B}$ can be considered as a convolution matrix of a measurement set up measuring the PCDE. In the case of multicode signals and a PCDE measurement, the function $\mathbf{f}$ can be expressed as a sum $f(\mathbf{x}^H \mathbf{G}^H \mathbf{C}_i^H \mathbf{C}_i \mathbf{G} \mathbf{x}) = \sum_{i=1}^{K} \mathbf{x}^H \mathbf{G}^H \mathbf{C}_i^H \mathbf{C}_i \mathbf{G} \mathbf{x}$ or a maximum value $\max(\mathbf{x}^H \mathbf{G}^H \mathbf{C}_i^H \mathbf{C}_i \mathbf{G} \mathbf{x})$, where K is the number of spreading codes used.

There are several possibilities to express the term $f_1(\mathbf{x})$ in a multicode system. In the case the matrix $\mathbf{C}_i$ corresponds the matrix $\mathbf{G}^{-1}$, the term $f_1(\mathbf{x})$ becomes $f_1(\mathbf{x}) = \mathbf{x}^H \mathbf{x}$ and in this case it is not necessary to perform the part of the multiplication $\mathbf{G}^H \mathbf{C}_i^H \mathbf{C}_i \mathbf{G}$ at all, since the product $\mathbf{G}^H \mathbf{C}_i^H \mathbf{C}_i \mathbf{G}$ becomes an identity matrix $\mathbf{I}$. The term $f_1(\mathbf{x}) = \mathbf{x}^H \mathbf{x}$ can be accomplished by forming an effective value of the optimisation signal $\mathbf{x}$.

The matrix $\mathbf{C}_i$ may also be an identity matrix $\mathbf{I}$. In that case, the term $f_1(\mathbf{x})$ becomes $f_1(\mathbf{x}) = \mathbf{x}^H \mathbf{G}^H \mathbf{G} \mathbf{x}$. The term $f_1(\mathbf{x}) = \mathbf{x}^H \mathbf{G}^H \mathbf{G} \mathbf{x}$ can be accomplished by filtering the optimisation signal x with a suitable FIR filter defined by the matrix $\mathbf{G}$ and forming an effective value of the result. In the case the convolution matrix $\mathbf{G}$ is omitted, the term $f_1(\mathbf{x})$ becomes $f_1(\mathbf{x}) = \mathbf{x}^H \mathbf{S}_i^H \mathbf{B}^H \mathbf{S}_i \mathbf{B} \mathbf{x}$ and the term $f_1(\mathbf{x})$ can be accomplished by multiplying the optimisation signal $\mathbf{x}$ with a spreading code and filtering the product by a root raised cosine filter defined by matrix $\mathbf{B}$ and forming an effective value of the result.

The term $f_2(\mathbf{x})$ can be expressed as

$$f_2(\mathbf{x}) = \| \mathbf{y} - \mathbf{Gx} - F(\mathbf{y} - \mathbf{Gx}, A) \|_2^2 \qquad (5)$$

where the operation $\|$ is a length norm of the overshoot exceeding the threshold A. The non-linear function $F(\mathbf{y} - \mathbf{Gx}, A)$ can be defined as

$$F(\mathbf{y} - \mathbf{Gx}, A) = \begin{cases} \mathbf{y} - \mathbf{Gx} & |\mathbf{y} - \mathbf{Gx}| \le A \\ \dfrac{A}{|\mathbf{y} - \mathbf{Gx}|}(\mathbf{y} - \mathbf{Gx}) & |\mathbf{y} - \mathbf{Gx}| > A \end{cases} \qquad (6)$$

and its maximum value is limited to the threshold A. The term $f_2(\mathbf{x})$ defines the effective value of the error vector 526 exceeding the threshold A. The matrices **B** and **G** as filters locate in the minimizer 400. The non-linear function $F(\mathbf{y} - \mathbf{Gx}, A)$ can be accomplished using, for example, a CORDIC (COordinate Rotation DIgital Computer) algorithm.

The minimization $\min(J(\mathbf{x}))$ can be performed, for example, by an iterative algorithm. The iterative algorithm may utilize a gradient descent. The minimization of the cost function with respect to argument **x** can now be expressed as

$$\hat{\mathbf{x}}_{n+1} = \hat{\mathbf{x}}_n - \mu \nabla J(\hat{\mathbf{x}}_n) \qquad (7)$$

where a hat $\hat{\mathbf{x}}$ on the variable means an estimate of the variable in the iteration, $\mu$ is a weight of the iteration ($0 \le \mu \le 1$) having a real number value and the differential operator $\nabla$ (nabla) is a gradient (For example, in three dimensional Cartesian coordinates the nabla is $\nabla = \dfrac{\partial}{\partial x}\mathbf{i} + \dfrac{\partial}{\partial y}\mathbf{j} + \dfrac{\partial}{\partial z}\mathbf{k}$, where x, y and z are axis of a Cartesian coordinates, **i**, **j** and **k** are unit vectors of the axis and the terms associated with the unit vectors are partial differential operators applied to a desired scalar function. The notation x, y, z, **i** and **j** should not be mixed with the variables mentioned elsewhere in the application). A gradient of a scalar function is a vector function.

The equation (7) can further be expressed as

$$\hat{\mathbf{x}}_{n+1} = \hat{\mathbf{x}}_n - \mu[\alpha \mathbf{P}\hat{\mathbf{x}}_n - (1 - \alpha)\mathbf{G}^H\mathbf{z}] \qquad (8)$$

where **P** can be either $\mathbf{P} = \mathbf{G}^H\mathbf{C}^H\mathbf{CG}$, $\mathbf{P} = \mathbf{G}^H\mathbf{C}_i^H\mathbf{C}_i\mathbf{G}$ or $\mathbf{P} = \mathbf{I}$. The term $\mathbf{P}\hat{\mathbf{x}}_n$ corresponds to the term $f_1(\mathbf{x})$ in (1) and the term $\mathbf{G}^H\mathbf{z}$ corresponds to the term $f_2(\mathbf{x})$ in (1). In the case the matrix **C** corresponds the matrix $\mathbf{G}^{-1}$, the term $f_1(\mathbf{x})$ becomes $f_1(\mathbf{x}) = \mathbf{x}^H\mathbf{x}$ and in this case it is not necessary to perform the part of the multiplication $\mathbf{G}^H\mathbf{C}^H\mathbf{CG}$ at all, since the product $\mathbf{G}^H\mathbf{C}^H\mathbf{CG}$ becomes an identity matrix **I**. The $i^{th}$ element of a vector **z** can be expressed as

$$z_i = \begin{cases} \mathbf{y}_i - \mathbf{g}_i\hat{\mathbf{x}}_n - Ae^{j\arg(y_i - g_i\hat{x}_n)} & \text{if } |\mathbf{y}_i - \mathbf{g}_i\hat{\mathbf{x}}| > A \\ 0 & \text{if } |\mathbf{y}_i - \mathbf{g}_i\hat{\mathbf{x}}| \le A \end{cases} \qquad (9)$$

where $\mathbf{g}_i$ is the $i^{th}$ row vector of the matrix **G**, and j is an imaginary unit fulfilling an equation $j^2 = -1$. After a number of iterations an estimate of the optimisation signal vector $\hat{\mathbf{x}}_n$ is found and the vector $\hat{\mathbf{x}}_n$ at least approximately minimizes the cost function $J(\mathbf{x})$.

The matrix **G** (as well as other matrices) can be realized as a finite impulse response (FIR) filter (Fig. 4 filter 402) which may be programmable in order to make the filter adaptive. Fig. 6 shows a block diagram of a FIR filter. The FIR filter comprises delay elements 600, weight units 602 and a summer 604. Each delay element 600 delays an input signal x, and the delayed signal elements $x_i$ are weighted by the desired weight coefficient $g_i$ of the weight units 602. The weighted signal elements are summed in a summer 604. Weights may be real or complex.

The iterative minimization can be considered to proceed in the following manner. Consider the situation in Fig. 5. Assume that the overshoot (arrow 526) of the transmission signal relating to the symbol 504 is clear without clipping signal. The iterative algorithm then chooses a vector **x** which may cause the overshoot to disappear completely. The absolute value of the first estimate of the optimisation signal vector $\hat{\mathbf{x}}_1$ and first weighted term $\alpha f_1(\hat{\mathbf{x}}_1)$ can be considered large in this case. The second term $(1 - \alpha)f_2(\hat{\mathbf{x}}_1)$, however, becomes zero, since the clipping signal cancels the overshoot. In the next step of iteration, the minimization decreases the value of the next estimated optimisation signal in order to decrease the value of the cost function. This may lead to the situation that a small overshoot appears. Hence, both terms $\alpha f_1(\hat{\mathbf{x}}_2)$ and $(1 - \alpha)f_2(\hat{\mathbf{x}}_2)$ have a small value. Finally, after a number of iterations, the value of the estimated optimisation signal approaches such a situation that there is only a small overshoot or no overshoot at all and the value of $|\mathbf{y} - \mathbf{G}\hat{\mathbf{x}}_n|$ is close to the threshold A.

After the cost function has been minimized and a suitable optimisation signal x has been found, a clipping signal s is formed by filtering the optimisation signal according to the spectrum emission mask requirements (filter 402 in Fig. 4) of the radio system. The clipping signal s is then subtracted from the transmission signal y by adding the clipping signal s negatively to the transmission signal in the summer 404. The requirements of the spectrum define the allowed bandwidth and the stop band attenuation, or the width of the signal frequency band.

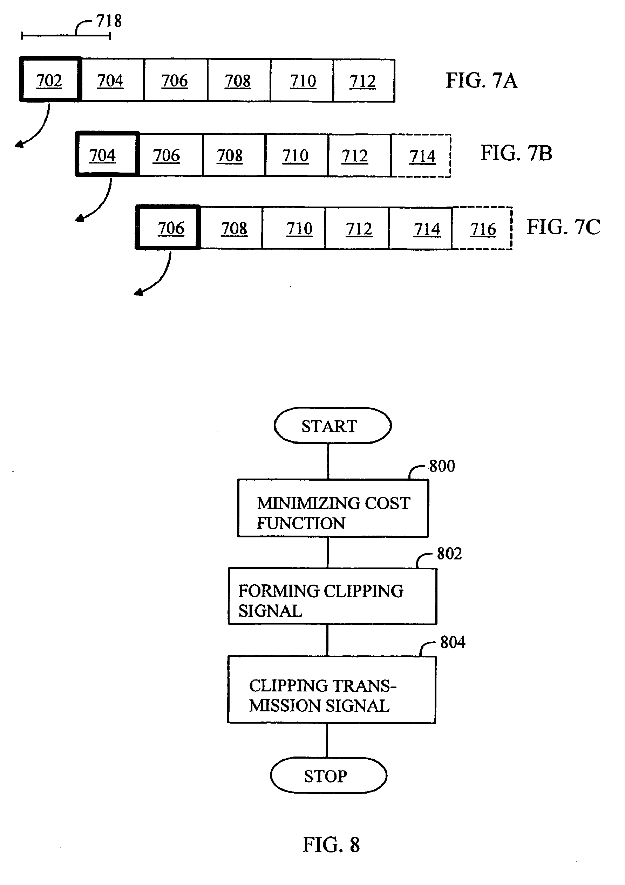

Fig. 7A to 7C illustrate a division of the transmission signal into subsignals. To avoid processing of a large number of samples in a long transmission signal **y,** the transmission signal 700 in a process window can be divided into at least two subsignals 702 to 712 each having a predetermined sequential length (a predetermined number of samples). The window determines a predetermined length of the sample sequence of the transmission signal **y.** The cost function can be minimized with respect to the optimisation signal associated to each subsignal 702 to 712 one after another. The optimisation signal obtained in the minimization is filtered according to the spectrum emission mask by convoluting the optimisation vector **x** and the filtering values of vector **g.** The clipping signal of the form **s = Gx** is then subtracted from at least the subsignal which the optimisation signal is associated to.

Because of convolution, the sequence of samples of the clipping signal becomes longer than that of the subsignal which it is associated to. Hence, the clipping signal formed for one subsignal may be subtracted from many subsignals in principal. The clipping signal and its sequential length are illustrated with a segment of line 718. The length also corresponds to the convolution matrix **G.** In this example, the clipping signal extent from the beginning of the first subsignal 702 to the middle of the second subsignal 704. Hence, the subtraction of the first clipping signal $\mathbf{s}_1$, which is based on the first minimization and forming of the first optimisation signal, may be performed to the first subsignal $\mathbf{y}_1$ 702 and to the first half of the second subsignal $\mathbf{y}_2$ 704 which the clipping signal **s** has a non-zero effect to.

After the first subtraction, a sequence of a new subsignal 714 is added to the end of the window and the first subsignal 702 is removed from the window as shown in Fig. 7B. The minimisation is now performed relating to the second subsignal 704. The second subsignal may the one from which the first clipping signal has not been subtracted or the second subsignal may be the one from which the first clipping signal has been subtracted. The minimisation, the forming of optimisation signal and the subtraction are performed in the similar manner as in the case of the first subsignal. After that a sequence of the next subsignal 716 is added to the end of the transmission signal in process. The process continues in this manner as long as the transmission signal is transmitted.

The values of a previous iteration of the optimisation signal **x** can be used as initial values for the clipping procedure of a present subsignal.

Fig. 8 presents a flow chart of the method of clipping a transmission signal in a radio system. The transmission signal is clipped in the transmitter before transmission in order to reduce the strength of at least one peak of the transmission signal exceeding a predetermined threshold. The clipping can be performed according to the following steps. In step 800, a minimization of a cost function is performed with respect to an optimisation signal, the cost function having weighted terms as a function of the optimisation signal, the terms relating to an effective modulation distortion and an effective overshoot exceeding the predetermined threshold. In step 802, a clipping signal is formed by filtering the optimisation signal formed as a result of the minimization according to the spectrum emission mask requirements of the radio system. In step 804, the clipping signal is subtracted from the transmission signal.

The implementation can be accomplished, for example, by means of specific equipment providing the required operations, such as an application-specific integrated circuit (ASIC), or separate logic components. The implementation may also be accomplished, for example, by means of software, a base station comprising a microprocessor, where the operations of the method described above are carried out in the form of software.

In a case of software solution, a computer program product in a transmitter may encode a computer program of instructions for executing a computer process for clipping a transmission signal before transmission in order to reduce the strength of at least one peak of the transmission signal exceeding a predetermined threshold.

A computer program can be distributed in a distribution medium readable by a computer. A computer program of instructions can be encoded for executing the computer process for clipping a transmission signal in the transmitter before transmission in order to reduce the strength of at least one peak of the transmission signal exceeding a predetermined threshold.

The distribution medium of the computer program may comprise a computer readable medium, a program storage medium, a record medium, a computer readable memory, a computer readable software distribution package, a computer readable signal, a computer readable telecommunications signal, and a computer readable compressed software package.

Even though the invention is described above with reference to examples according to the accompanying drawings, it is clear that the invention is not restricted thereto but can be modified in several ways within the scope of the appended claims.

## Claims

1. A method of clipping a transmission signal in a radio system, the method comprising clipping a transmission signal in the transmitter before transmission in order to reduce the strength of at least one peak of the trans- mission signal exceeding a predetermined threshold, **characterized by** performing (800) a minimization of a cost function with respect to an optimisation signal, the cost function having weighted terms as a function of the optimisation signal, the terms relating to an effective modulation distortior of the clipped transmission signal and an effective overshoot of the clipped transmission signal exceeding the predetermined threshold; forming (802) a clipping signal by filtering the optimisation signal formed as a result of the minimization according to the spectrum emission mask requirements of the radio system; and subtracting (804) the clipping signal from the transmission signal.

2. The method of claim 1, **characterized by** performing (800) an iterative algorithm using a gradient descent for minimizing the cost function.

3. The method of claim 1, **characterized by** forming (802) a term relating to an effective modulation distortion as an effective strength of the optimisation signal.

4. The method of claim 1, **characterized by** forming (802) a term relating to an effective modulation distortion as an effective strength of the optimisation signal is multiplied by a spreading code and filtered by a root raised cosine filtering.

5. The method of claim 1 , **characterized by** forming (802) a term relating to an effective overshoot exceeding the predetermined threshold by forming a difference of the transmission signal and the clipping signal by subtracting the clipping signal from the transmission signal, and forming the effective value of the difference of the transmission signal and the clipping signal, if the difference of the transmission signal and the clipping signal is greater than the predetermined threshold.

6. The method of claim 1, **characterized by** processing the transmission signal in a window of a predetermined sequential length, the processing comprising dividing the transmission signal in the window into at least two subsignals (702 to 716) of predetermined sequential lengths; performing (802) the minimization of a cost function with respect to an optimisation signal associated to a subsignal (702 to 716) for forming a clipping signal of a predetermined length; and subtracting the clipping signal from at least the subsignal (702 to 716) which the optimisation signal is associated to.

7. The method of claim 1, **characterized by** subtracting the clipping signal from all subsignals which the optimisation signal (718) has a non-zero effect to.

8. A transmitter of the clipped transmission signal in a radio system, the transmitter being configured to clip a transmission signal before transmission in order to reduce the strength of at least one peak of the transmission signal exceeding a predetermined threshold, **characterized in that** the transmitter comprises a clipper comprising a minimizer (400) for minimizing of a cost function with respect to an optimisation signal, the cost function having weighted terms as a function of the optimisation signal, the terms relating to an effective modulation distortion of the clipped transmission signal and an effective overshoot of the clipped transmission signal exceeding the predetermined threshold; a filter (402) for forming a clipping signal by filtering the optimisation signal formed as a result of the minimization according to the spectrum emission mask requirements of the radio system; and an adder (404) for subtracting the clipping signal from the transmission signal.

9. The transmitter of claim 8, **characterized in that** the minimizer (400) is configured to perform an iterative algorithm using a gradient descent for minimizing the cost function.

10. The transmitter of claim 8, **characterized in that** the minimizer (400) is configured to form a term relating to an effective modulation distortion as an effective strength of the optimisation signal.

11. The transmitter of claim 8, **characterized in that** the minimizer (400) is configured to form a term relating to an effective modulation distortion as an effective strength of the optimisation signal multiplied by a spreading code and filtered by a root raised cosine filtering.

12. The transmitter of claim 8, **characterized in that** the minimizer (400) is configured to form a term relating to an effective overshoot exceeding the predetermined threshold by forming a difference of the transmission signal and the clipping signal by subtracting the clipping signal from the transmission signal, and the minimizer (400) is configured to form the effective value of the difference of the transmission signal and the clipping signal, if the difference of the transmission signal and the clipping signal is greater than the predetermined threshold.

13. The transmitter of claim 8, **characterized in that** the clipper (212) is configured to process the transmission signal in a window of a predetermined length and to divide the transmission signal in the window into at least two subsignals (702 to 716) of predetermined lengths; the minimizer (400) in the clipper is configured to perform a minimization of a cost function with respect to an optimisation signal associated to a subsignal for forming a clipping signal of a predetermined length; and the adder (404) in the clipper is configured to subtract the clipping signal from at least the subsignal which the optimisation signal is associated to.

14. The transmitter of claim 8, **characterized in that** the adder (404) of the clipper (212) is configured to subtract the clipping signal from all subsignals which the optimisation signal (718) has a non-zero effect to.

15. A base station suitable for use in a radio system, the base station being configured to clip a transmission signal before transmission in order to reduce the strength of at least one peak of the transmission signal exceeding a predetermined threshold, **characterized in that** the base station comprises a minimizer (400) for minimizing of a cost function with respect to an optimisation signal, the cost function having weighted terms as a function of the optimisation signal, the terms relating to an effective modulation distortion of the clipped transmission signal and an effective overshoot of the clipped transmission signal exceeding the predetermined threshold; a filter (402) for forming a clipping signal by filtering the optimisation signal formed as a result of the minimization according to the spectrum emission mask requirements of the radio system; and an adder (404) for subtracting the clipping signal from the transmission signal.

**Patentansprüche**

1. Verfahren zum Begrenzen eines Sendesignals in einem Funksystem, das Verfahren Begrenzen eines Sendesignals in dem Sender vor dem Senden umfassend, um die Stärke mindestens einer Spitze des Sendesignals, die einen im Voraus bestimmten Schwellenwert übersteigt, zu reduzieren, **gekennzeichnet durch** Durchführen (800) einer Minimierung einer Kostenfunktion in Bezug auf ein Optimierungssignal, wobei die Kostenfunktion gewichtete Terme als eine Funktion des Optimierungssignals aufweist, wobei die Terme mit einer effektiven Modulationsverzerrung des begrenzten Sendesignals und einer effektiven Überschreitung des begrenzten Sendesignals, die den im Voraus bestimmten Schwellenwert übersteigt, in Beziehung stehen; Bilden (802) eines Begrenzungssignals **durch** Filtern des als ein Ergebnis der Minimierung gemäß den Spektrumsausstrahlungsmaskenanforderungen des Funksystems gebildeten Optimierungssignals; und Subtrahieren (804) des Begrenzungssignals von dem Sendesignal.

2. Verfahren nach Anspruch 1, **gekennzeichnet durch** Durchführen (800) eines iterativen Algorithmus, der eine Gradientensenkung zur Minimierung der Kostenfunktion verwendet.

3. Verfahren nach Anspruch 1, **gekennzeichnet durch** Bilden (802) eines Terms, der zu einer effektiven Modulationsverzerrung in Beziehung steht, als eine effektive Stärke des Optimierungssignals.

4. Verfahren nach Anspruch 1, **gekennzeichnet durch** Bilden (802) eines Terms, der zu einer effektiven Modulationsverzerrung in Beziehung steht, als eine effektive Stärke des Optimierungssignals, das mit einem Spreizcode multipliziert und **durch** eine Wurzel-erhöhte Kosinusfilterung gefiltert wird.

**5.** Verfahren nach Anspruch 1, **gekennzeichnet durch** Bilden (802) eines Terms, der zu einer effektiven Überschreitung, die den im Voraus bestimmten Schwellenwert übersteigt, in Beziehung steht, **durch** Bilden einer Differenz des Sendesignals und des Begrenzungssignals **durch** Subtrahieren des Begrenzungssignals von dem Sendesignal und Bilden des effektiven Werts der Differenz des Sendesignals und des Begrenzungssignals, wenn die Differenz des Sendesignals und des Begrenzungssignals größer ist als der im Voraus bestimmte Schwellenwert.

**6.** Verfahren nach Anspruch 1, **gekennzeichnet durch** Verarbeiten des Sendesignals in einem Fenster einer im Voraus bestimmten sequenziellen Länge, die Verarbeitung umfassend Aufteilen des Sendesignals in dem Fenster in mindestens zwei Teilsignale (702 bis 716) von im Voraus bestimmten sequenziellen Längen; Durchführen (802) der Minimierung einer Kostenfunktion in Bezug auf ein mit einem Teilsignal (702 bis 716) assoziierten Optimierungssignal zum Bilden eines Begrenzungssignals einer im Voraus bestimmten Länge; und Subtrahieren des Begrenzungssignals von mindestens dem Teilsignal (702 bis 716), mit dem das Optimierungssignal assoziiert ist.

**7.** Verfahren nach Anspruch 1, **gekennzeichnet durch** Subtrahieren des Begrenzungssignals von allen Teilsignalen, auf die das Optimierungssignal (718) eine Wirkung ungleich null hat.

**8.** Sender, geeignet für Verwendung in einem Funksystem, wobei der Sender konfiguriert ist, um ein Sendesignal vor dem Senden zu begrenzen, um die Stärke mindestens einer Spitze des Sendesignals, die einen im Voraus bestimmten Schwellenwert übersteigt, zu reduzieren, **dadurch gekennzeichnet, dass** der Sender einen Begrenzer umfasst, der einen Minimierer (400) zum Minimieren einer Kostenfunktion in Bezug auf ein Optimierungssignal, wobei die Kostenfunktion gewichtete Terme als eine Funktion des Optimierungssignals aufweist, wobei die Terme mit einer effektiven Modulationsverzerrung des begrenzten Sendesignals und einer effektiven Überschreitung des begrenzten Sendesignals, die den im Voraus bestimmten Schwellenwert übersteigt, in Beziehung stehen; ein Filter (402) zum Bilden eines Begrenzungssignals durch Filtern des als ein Ergebnis der Minimierung gemäß den Spektrumsausstrahlungsmaskenanforderungen des Funksystems gebildeten Optimierungssignals; und einen Addierer (404) zum Subtrahieren des Begrenzungssignals von dem Sendesignal umfasst.

**9.** Sender nach Anspruch 8, **dadurch gekennzeichnet, dass** der Minimierer (400) konfiguriert ist zum Durchführen eines iterativen Algorithmus, der eine Gradientensenkung zur Minimierung der Kostenfunktion verwendet.

**10.** Sender nach Anspruch 8, **dadurch gekennzeichnet, dass** der Minimierer (400) konfiguriert ist zum Bilden eines Terms, der zu einer effektiven Modulationsverzerrung in Beziehung steht, als eine effektive Stärke des Optimierungssignals.

**11.** Sender nach Anspruch 8, **dadurch gekennzeichnet, dass** der Minimierer (400) konfiguriert ist zum Bilden eines Terms, der zu einer effektiven Modulationsverzerrung in Beziehung steht, als eine effektive Stärke des Optimierungssignals, multipliziert mit einem Spreizcode und gefiltert durch eine Wurzel-erhöhte Kosinusfilterung.

**12.** Sender nach Anspruch 8, **dadurch gekennzeichnet, dass** der Minimierer (400) konfiguriert ist zum Bilden eines Terms, der zu einer effektiven Überschreitung, die den im Voraus bestimmten Schwellenwert übersteigt, in Beziehung steht, durch Bilden einer Differenz des Sendesignals und des Begrenzungssignals durch Subtrahieren des Begrenzungssignals von dem Sendesignal, und der Minimierer (400) konfiguriert ist zum Bilden des effektiven Werts der Differenz des Sendesignals und des Begrenzungssignals, wenn die Differenz des Sendesignals und des Begrenzungssignals größer ist als der im Voraus bestimmte Schwellenwert.

**13.** Sender nach Anspruch 8, **dadurch gekennzeichnet, dass** der Begrenzer (212) konfiguriert ist zum Verarbeiten des Sendesignals in einem Fenster einer im Voraus bestimmten Länge und zum Aufteilen des Sendesignals in dem Fenster in mindestens zwei Teilsignale (702 bis 716) von im Voraus bestimmten Längen; der Minimierer (400) in dem Begrenzer konfiguriert ist zum Durchführen einer Minimierung einer Kostenfunktion in Bezug auf ein mit einem Teilsignal assoziierten Optimierungssignal zum Bilden eines Begrenzungssignals einer im Voraus bestimmten Länge; und der Addierer (404) in dem Begrenzer konfiguriert ist zum Subtrahieren des Begrenzungssignals von mindestens dem Teilsignal, mit dem das Optimierungssignal assoziiert ist.

**14.** Sender nach Anspruch 8, **dadurch gekennzeichnet, dass** der Addierer (404) des Begrenzers (212) konfiguriert ist zum Subtrahieren des Begrenzungssignals von allen Teilsignalen, auf die das Optimierungssignal (718) eine Wirkung ungleich null hat.

**15.** Basisstation, geeignet für Verwendung in einem Funksystem, wobei die Basisstation konfiguriert ist zum Begrenzen eines Sendesignals vor dem Senden, um die Stärke mindestens einer Spitze des Sendesignals, die einen im Voraus bestimmten Schwellenwert übersteigt, zu reduzieren, **dadurch gekennzeichnet, dass** die Basisstation einen Minimierer (400) zum Minimieren einer Kostenfunktion in Bezug auf ein Optimierungssignal, wobei die Kostenfunktion gewichtete Terme als eine Funktion des Optimierungssignals aufweist, wobei die Terme mit einer effektiven Modulationsverzerrung des begrenzten Sendesignals und einer effektiven Überschreitung des begrenzten Sendesignals, die den im Voraus bestimmten Schwellenwert übersteigt, in Beziehung stehen; ein Filter (402) zum Bilden eines Begrenzungssignals durch Filtern des als ein Ergebnis der Minimierung gemäß den Spektrumsausstrahlungsmaskenanforderungen des Funksystems gebildeten Optimierungssignals; und einen Addierer (404) zum Subtrahieren des Begrenzungssignals von dem Sendesignal umfasst.

## Revendications

1. Un procédé d'écrêtage d'un signal de transmission dans un système radio, le procédé comprenant l'écrêtage d'un signal de transmission dans l'émetteur avant la transmission afin de réduire la puissance d'au moins une crête du signal de transmission dépassant un seuil prédéterminé, **caractérisé par** l'exécution (800) d'une minimisation d'une fonction de coût par rapport à un signal d'optimisation, la fonction de coût possédant des termes pondérés en tant que fonction du signal d'optimisation, les termes portant sur une distorsion de modulation effective du signal de transmission écrêté et un dépassement effectif du signal de transmission écrêté dépassant le seuil prédéterminé, la formation (802) d'un écrêtage de signal par le filtrage du signal d'optimisation formé en conséquence de la minimisation selon les exigences de masque d'émission de spectre du système radio, et la soustraction (804) du signal écrêté du signal de transmission.

2. Le procédé selon la revendication 1, **caractérisé par** l'exécution (800) d'un algorithme itératif au moyen d'une descente de gradient destinée à minimiser la fonction de coût.

3. Le procédé selon la revendication 1, **caractérisé par** la formation (802) d'un terme portant sur une distorsion de modulation effective en tant que puissance effective du signal d'optimisation.

4. Le procédé selon la revendication 1, **caractérisé par** la formation (802) d'un terme portant sur une distorsion de modulation effective en tant que puissance effective du signal d'optimisation qui est multiplié par un code d'étalement et filtré par un filtrage de cosinus racine carrée.

5. Le procédé selon la revendication 1, **caractérisé par** la formation (802) d'un terme portant sur un dépassement effectif dépassant le seuil prédéterminé par la formation d'une différence entre le signal de transmission et le signal écrêté par la soustraction du signal écrêté du signal de transmission, et la formation de la valeur effective de la différence entre le signal de transmission et le signal écrêté, si la différence entre le signal de transmission et le signal écrêté est supérieure au seuil prédéterminé.

6. Le procédé selon la revendication 1, **caractérisé par** le traitement du signal de transmission dans une fenêtre d'une longueur séquentielle prédéterminée, le traitement comprenant la division du signal de transmission dans la fenêtre en au moins deux sous-signaux (702 à 716) de longueurs séquentielles prédéterminées, l'exécution (802) de la minimisation d'une fonction de coût par rapport à un signal d'optimisation associé à un sous-signal (702 à 716) pour la formation d'un signal d'écrêtage d'une longueur prédéterminée, et la soustraction du signal écrêté d'au moins le sous-signal (702 à 716) auquel le signal d'optimisation est associé.

7. Le procédé selon la revendication 1, **caractérisé par** la soustraction du signal écrêté de tous les sous-signaux sur lesquels le signal d'optimisation (718) possède un effet non nul.

8. Un émetteur adapté à une utilisation dans un système radio, l'émetteur étant configuré de façon à écrêter un signal de transmission avant la transmission afin de réduire la puissance d'au moins une crête du signal de transmission dépassant un seuil prédéterminé, **caractérisé en ce que** l'émetteur comprend un écrêteur comprenant un minimiseur (400) destiné à minimiser une fonction de coût par rapport à un signal d'optimisation, la fonction de coût possédant des termes pondérés en tant que fonction du signal d'optimisation, les termes portant sur une distorsion de modulation effective du signal de transmission écrêté et un dépassement effectif du signal de transmission écrêté dépassant le seuil prédéterminé, un filtre (402) pour la formation d'un signal d'écrêtage par le filtrage du signal d'optimisation formé en conséquence de la minimisation selon les exigences de masque d'émission de spectre du système radio, et un additionneur (404) pour la soustraction du signal écrêté du signal de transmission.

**9.** L'émetteur selon la revendication 8, **caractérisé en ce que** le minimiseur (400) est configuré de façon à exécuter un algorithme itératif au moyen d'une descente de gradient destinée à minimiser la fonction de coût.

**10.** L'émetteur selon la revendication 8, **caractérisé en ce que** le minimiseur (400) est configuré de façon à former un terme portant sur une distorsion de modulation effective en tant que puissance effective du signal d'optimisation.

**11.** L'émetteur selon la revendication 8, **caractérisé en ce que** le minimiseur (400) est configuré de façon à former un terme portant sur une distorsion de modulation effective en tant que puissance effective du signal d'optimisation multiplié par un code d'étalement et filtré par un filtrage de cosinus racine carrée.

**12.** L'émetteur selon la revendication 8, **caractérisé en ce que** le minimiseur (400) est configuré de façon à former un terme portant sur un dépassement effectif dépassant le seuil prédéterminé par la formation d'une différence entre le signal de transmission et le signal écrêté par la soustraction du signal écrêté du signal de transmission, et le minimiseur (400) est configuré de façon à former la valeur effective de la différence entre le signal de transmission et le signal écrêté, si la différence entre le signal de transmission et le signal écrêté est supérieure au seuil prédéterminé.

**13.** L'émetteur selon la revendication 8, **caractérisé en ce que** l'écrêteur (212) est configuré de façon à traiter le signal de transmission dans une fenêtre d'une longueur prédéterminée et à diviser le signal de transmission dans la fenêtre en au moins deux sous-signaux (702 à 716) de longueurs prédéterminées, le minimiseur (400) dans l'écrêteur est configuré de façon à exécuter une minimisation d'une fonction de coût par rapport à un signal d'optimisation associé à un sous-signal pour la formation d'un signal d'écrêtage d'une longueur prédéterminée, et l'additionneur (404) dans l'écrêteur est configuré de façon à soustraire le signal écrêté d'au moins le sous-signal auquel le signal d'optimisation est associé.

**14.** L'émetteur selon la revendication 8, **caractérisé en ce que** l'additionneur (404) de l'écrêteur (212) est configuré de façon à soustraire le signal écrêté de tous les sous-signaux sur lesquels le signal d'optimisation (718) possède un effet non nul.

**15.** Une station de base adaptée à une utilisation dans un système radio, la station de base étant configurée de façon à écrêter un signal de transmission avant la transmission afin de réduire la puissance d'au moins une crête du signal de transmission dépassant un seuil prédéterminé, **caractérisé en ce que** la station de base comprend un minimiseur (400) destiné à minimiser une fonction de coût par rapport à un signal d'optimisation, la fonction de coût possédant des termes pondérés en tant que fonction du signal d'optimisation, les termes portant sur une distorsion de modulation effective du signal de transmission écrêté et un dépassement effectif du signal de transmission écrêté dépassant le seuil prédéterminé, un filtre (402) pour la formation d'un signal d'écrêtage par le filtrage du signal d'optimisation formé en conséquence de la minimisation selon les exigences de masque d'émission de spectre du système radio, et un additionneur (404) pour la soustraction du signal écrêté du signal de transmission

GMSC 102

GGSN 103

MSC 100

SGSN 101

BSC 106

104

BS 108

UE 110

**FIG. 1**

220

POWER AMP 218

RF 216

D/A 214

212

CLIPPER

208

Σ I

Σ Q

210

MOD 206A

DS 204A

MOD 202A

DSP 200A

MOD 206B

DS 204B

MOD 202B

DSP 200B

CNTL 222

**FIG. 2**

STRENGTH

302

304

A

300

T

FIG. 3A

STRENGTH

302

304

300

T

FIG. 3B

y

DELAY 406

+ + 404 y - Gx

−

s = Gx

A α μ

MINIMI-
ZATION

FILTER 402

400

412

FIG. 4

FIG. 5

FIG. 6

718

| 702 | 704 | 706 | 708 | 710 | 712 |

FIG. 7A

| 704 | 706 | 708 | 710 | 712 | 714 |

FIG. 7B

| 706 | 708 | 710 | 712 | 714 | 716 |

FIG. 7C

START

800

MINIMIZING COST FUNCTION

802

FORMING CLIPPING SIGNAL

804

CLIPPING TRANS-MISSION SIGNAL

STOP

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2402308 A